# EUROPEAN PATENT SPECIFICATION

(11) **EP 0 197 454 B1**
(45) Date of publication and mention of the grant of the patent: **28.07.1993**
(21) Application number: 86104272.9
(22) Date of filing: 27.03.1986
(51) Int. Cl.: H01L 21/76, H01L 21/316

(54) **Method for making semiconductor devices comprising insulating regions**
Verfahren zur Herstellung von Halbleiteranordnungen mit Isolationszonen
Procédé de fabrication de dispositifs semi-conducteurs comportant des régions d'isolation

(30) Priority: 01.04.1985 JP 68727/85
(43) Date of publication of application: 15.10.1986
(73) Proprietor: Matsushita Electronics Corporation, Kadoma-shi, Osaka 571 (JP)
(72) Inventor: Takebayashi, Koji, Takatsuki City, 569 (JP)
(74) Representative: Dr. Elisabeth Jung Dr. Jürgen Schirdewahn Dipl.-Ing. Claus Gernhardt

(56) References cited:
- GB-A- 2 123 605
- US-A- 4 088 516
- PATENT ABSTRACTS OF JAPAN vol. 8, no. 247 (E-278)(1684) 13 November 1984; & JP-A-59 124737 (MATSUSHITA) 18 July 1984
- PATENT ABSTRACTS OF JAPAN vol. 8, no. 167 (E-258)(1604) 02 August 1984; & JP-A-59 63741 (MATSUSHITA) 11 April 1984

## Description

The present invention relates to a method for making a semiconductor device.

In the fabrication of insulated gate semiconductor integrated circuits, particularly ultra-large scale integrated (LSI) circuits field insulating regions are usually formed by a method of local oxidation of silicon (LOCOS method) for separating formed elements from one another.

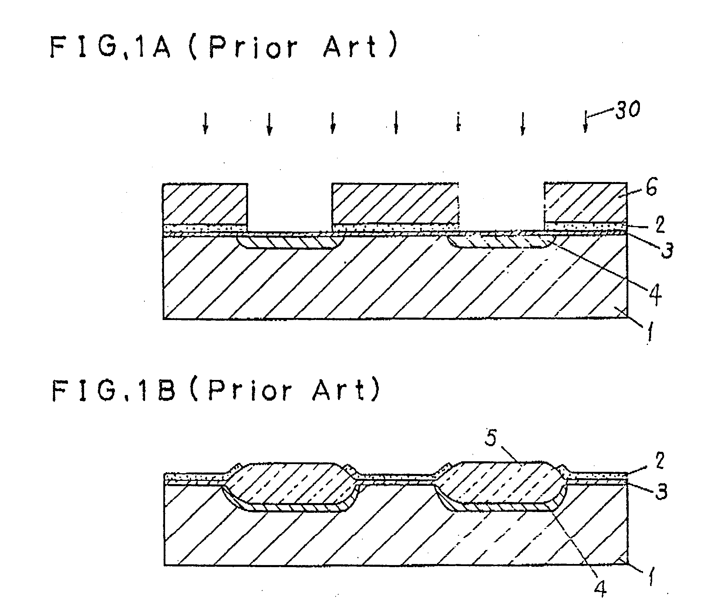

Referring now to FIGs.1A and 1B, a prior method or process for making semiconductor integrated circuits is elucidated. As shown in FIG.1A, a silicon dioxide layer or film 3 is formed over a substrate 1. Then, ion implanted regions 4 are formed by implanting impurities by using silicon nitride layers or films 2 as a mask. Then, selective local oxidation is carried out to form the field insulating regions 5 with their underlying channel stopper regions 4 (see FIG.1B). The p⁺ channel stopper regions 4 are provided for obtaining a high gate threshold voltage.

In the prior method, the formed channel stopper regions 4 are extended to n⁺ source and n⁺ drain regions 15. P⁺-n⁺ junctions are therefore formed therebetween and therefore the junction capacitance there increased. Such a higher capacitance reduces the operation speed of MOS circuits constituted thereof.

The channel stopper regions 4 are also extended to the underlying parts of insulation layers 12 which are provided under the gate electrodes 13, and thus decrease the gate width. Such a narrowed gate width W₁ reduces the current drive ability.

GB-A-2 123 605 discloses a method for fabricating an MOS integrated circuit structure, which comprises forming a film of silicon dioxide on a semiconductor substrate and further a film of silicon nitride thereon. The thickness of the film of silicon dioxide is greatest in the portions extending over the upper corners of the film of silicon nitride. The portions of the deposited film of silicon dioxide overlying the substrate and the upper plane of the silicon nitride-silicon dioxide dielectric is removed. However, a part of the relatively thick portions of the film of silicon dioxide at the outer edges of the dielectric layer will remain after the removing step in the form of tapered sidewalls extending downward and outwards from the upper surface of the dielectric layer to the surface of the substrate. Using the CVD (chemical vapor deposition) method a coating of SiO₂ is formed. The structure is therafter subjected to ion implantation whereby the silicon nitride and the thick sidewall portions of the first silicon dioxide act as a mask. In a subsequent thermal oxidation step a doped channel-stop region is thus formed which is self-aligned with the overlying field oxide layer. However, the deposition step takes relatively long time, in order to attain a complete SiO₂ coating over the upper corners of the silicon nitride-silicon dioxide dielectric.

The object of this invention is to provide an improved method for making a semiconductor device, wherein the extensions of the channel stopper regions formed under the channel stopper regions are prevented.

This object is achieved by the method for making a semi-conductor device in accordance with claim 1. Further advantageous examples of this method are indicated in the dependent claims.

The method according to the invention comprises the step of forming a coating of a silicon oxide derivative, which may be a silanol film consisting of a silanol (H₃SiOH) as a chief ingredient. This coating can be applied using a spine coating method and resulting in that the thickness of the silanol film is greater in the corner of an opening than in the central part thereof. This shape is due to the viscosity of the silanol. Accordingly after a subsequent heat treatment step the formed film of silicon dioxide is thicker in the corners than in the central part of the opening. This coating step is simple and allows considerably saving time.

The invention will be better understood and appreciated from the following detailed description in conjunction with the drawings. In the drawings:
FIG.1A is the cross-sectional elevation view of the substrate which includes a silicon dioxide film, a silicon nitride film, a masking member and ion implanted regions, according to a prior art method.
FIG.1B illustrates the substrate of FIG.1A after the selective local oxidation step.
FIG.2A is a cross-sectional elevation view of a substrate which includes a silicon dioxide layer, a silicon nitride layer and a masking member, according to the method of the present invention.
FIG.2B illustrates the substrate of FIG.2A with ion implanted regions and a silanol film.
FIG.2C illustrates the substrate of FIG.2B after a selective local oxidation step.
FIG.3 illustrates the substrate of FIG.2C with the source regions, the drain regions and the gate electrodes.
FIG.4 is a plan view of the substrate of FIG.3.

A semiconductor making method described here is particularly suited for ultra-large scale integrated circuits. In the following description, numerous specific details, such as a specific layer thickness, etc., are set forth in order to provide a thorough understanding of the presently preferred method. However, it will be obvious to one skilled in the art that the invention may be practiced without these specific details.

Also in the following description, the formation of n-channel transistors in metal-oxide-semiconductor(MOS) integrated circuits is described, wherein transistors are fabricated on a p-type single crystalline silicon substrate. It will be apparent to one skilled in the art that the method may be employed for the formation of p-channel transistors and using other technologies.

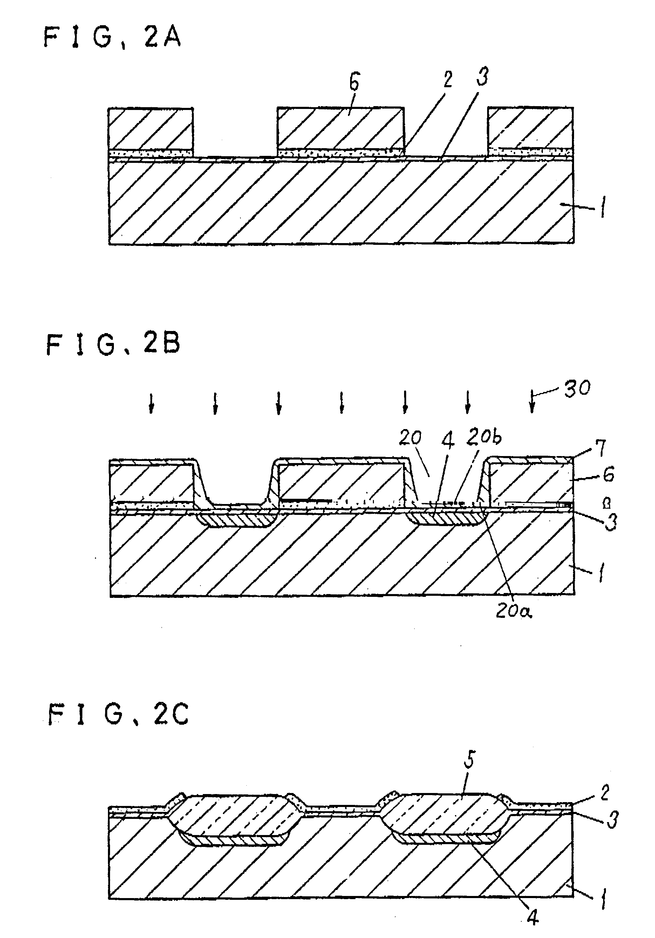

Referring now to FIG.2A, a section of a substrate 1 is illustrated. In the present preferred method, the substrate 1 is a low conductivity type substrate end is doped with a p-type dopant. A silicon dioxide layer 3 is formed by thermally oxidizing a surface of the substrate 1. A silicon nitride layer 2 as an anti-oxidization layer is formed on the silicon dioxide layer 3 by the C V D method. By way of example, the silicon dioxide layer 3 is approximately 50 nm thick, and the silicon nitride layer 2 is approximately 120 nm thick. Then, the silicon nitride layer 2 is patterned by using a photo-resist layer 6 as a mask.

Next, as shown in FIG.2B, a silanol film 7 which consists of silanol (H₃SiOH) as a principal resp. chief ingredient is formed over the resist layer 6 and the substrate 1. The silanol film 7 can be formed by a spine coating method resulting in such a shape that thickness of the silanol film 7 in an edge or corner 20a of an opening 20 is thicker than that in a center part 20b of the opening 20, when the silanol has a viscosity of about 1 cP (centipoise; 10⁻³ Pas). Then, the silanol film 7 is heat-treated at about 300°C for 20 minutes in order to form a silicon dioxide film 7. The formed silicon dioxide film 7 has thicker part in the edge 20a of the opening 20 and thinner part in the center 20b of the opening 20. By way of example, the thinner part 20b is about 100 nm thick.

As shown in FIG.2B, the substrate 1 is subject to impurity ion implantation as illustrated by lines 30, to form an ion implanting regions 4. Impurity ions are implanted into the substrate 1 through the center parts 20b of the openings 20, because in thin part the thicknesses of the silicon dioxide film 7 and the silicon dioxide layer 3 are thinner (about 150 nm) than in the edge parts 20a. The thicker parts 20a of the silicon dioxide film 7 prevent implantation the impurity ions into the substrate 1. Therefore, any unnecessary spreading of the ion implanting regions 4 can be prevented.

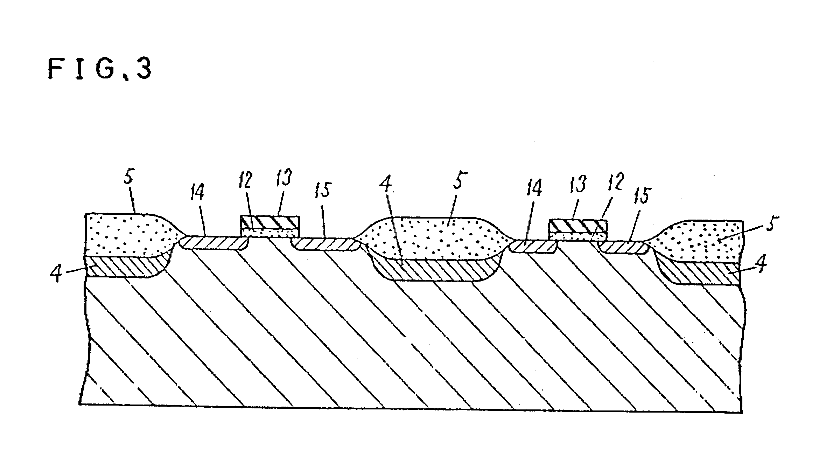

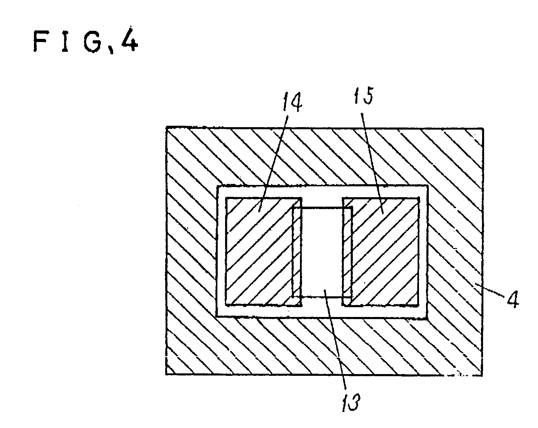

Next, the resist layer 6 and the silicon dioxide film 7 are removed by known process. Then, a LOCOS method is used to form the field insulating regions 5 with their underlying channel stopper regions 4. Thereafter, using a common process, a MOS-LSI circuit is produced. As shown in FIGs.3 and 4, the channel stopper regions 4 are separated from the drain regions 14 and the source regions 15 and are not extended to the underlying parts of the insulation layers 12 provided under the gate electrodes 13.

The channel stopper regions 4 are not formed over the edge of the field insulating regions 5 (see FIG.3). Therefore, undesirable junction capacitances between the source and the drain regions 14, 15 and the channel stopper regions 4 are not increased. Such low capacitances allow the production of semiconductor devices at high speed.

Furthermore, the gate width is not decreased since the channel stopper regions 4 are not extended to the underlying parts of the insulation layers 12 (see FIG. 4).

As has been described, the method for making a semiconductor device according to the present invention gives high speed and high current drive ability to produced semiconductor devises as the result or introducing the forming step of the silanol film before the ion implanting step.

## Claims

1. A method for making a semiconductor device, comprising the steps of
- forming a first film of silicon dioxide (3) on a semiconductor substrate (1) of one conductivity type;
- forming a film of silicon nitride (2) on the film of silicon dioxide (3);
- selectively removing the film of silicon nitride (2) to make an opening (20) to expose a surface of the first film of silicon dioxide (3);
- forming a coating of a silicon oxide derivative (7) on all the surface of the substrate;
- heat-treating the substrate (1) to convert the coating of silicon oxide derivative (7) to a second film of silicon dioxide;
- implanting ions of the one conductivity type into the substrate (1) through the films of silicon dioxide thereby to form an ion implanted region;
- removing the films of silicon dioxide; and
- selectively oxidizing the substrate by using the film of silicon nitride (2) as a mask, to form a selectively oxidized region as an isolation region having a channel stopper region (4) only under the selectively formed oxide film (5).

2. The method of claim 1, further comprising the steps of:
- forming a photoresist (6) on the film of silicon nitride (2), and
- selectively removing the film of silicon nitride (2) to make an opening (20) to expose the surface of the film of silicon dioxide (3) by using the photoresist as a mask.

3. The method of claim 1 or 2, wherein the silicon oxide derivative is a silanol film which consists of a silanol as a chief ingredient.

## Patentansprüche

1. Verfahren zur Herstellung einer Halbleitervorrichtung, umfassend die Schritte, daß
- eine erste dünne Siliciumdioxidschicht (3) auf einem Halbleitersubstrat (1) eines Leitfähigkeitstyps gebildet wird;
- eine dünne Siliciumnitridschicht (2) auf der dünnen Siliciumdioxidschicht (3) gebildet wird;
- die dünne Siliciumnitridschicht (2) selektiv entfernt wird, um eine Öffnung (20) herzustellen, die eine Oberfläche der ersten dünnen Siliciumdioxidschicht (3) exponiert;
- eine Beschichtung aus einem Siliciumoxidderivat (7) auf der gesamten Oberfläche des Substrats gebildet wird;
- das Substrat (1) wärmebehandelt wird, um die Beschichtung aus Siliciumoxidderivat (7) zu einer zweiten dünnen Siliciumdioxidschicht umzuwandeln;
- Ionen des einen Leitfähigkeitstyps durch die dünnen Siliciumdioxidschichten in das Substrat (1) implantiert werden, um hierdurch einen ionenimplantierten Bereich zu bilden;
- die dünnen Siliciumdioxidschichten entfernt werden; und
- das Substrat unter Verwendung der dünnen Siliciumnitridschicht (2) als Maske selektiv oxidiert wird, um einen selektiv oxidierten Bereich als Isolierbereich zu bilden, der einen Kanalsperrbereich (4) lediglich unter der selektiv gebildeten dünnen Oxidschicht (5) aufweist.

2. Verfahren nach Anspruch 1, weiter umfassend die Schritte, daß:
- ein Photoresist (6) auf der dünnen Siliciumnitridschicht (2) gebildet wird und
- die dünne Siliciumnitridschicht (2) selektiv entfernt wird, um eine Öffnung (20) herzustellen, um die Oberfläche der dünnen Siliciumdioxidschicht (3) unter Verwendung des Photoresists als Maske zu exponieren.

3. Verfahren nach Anspruch 1 oder 2, bei dem das Siliciumoxidderivat eine dünne Silanolschicht ist, die aus einem Silanol als Hauptbestandteil besteht.

## Revendications

1. Procédé pour fabriquer un dispositif semi-conducteur, comprenant les étapes consistant à :
- former un premier film de dioxyde de silicium (3) sur un substrat semi-conducteur (1) d'un type de conductivité;
- former un film de nitrure de silicium (2) sur le film de dioxyde de silicium (3);
- éliminer sélectivement le film de nitrure de silicium, (2) pour former une ouverture (20) afin d'exposer une surface du premier film de dioxyde de silicium (3);
- former un revêtement d'un dérivé d'oxyde de silicium (7) sur toute la surface du substrat;
- traiter thermiquement la surface (1) pour convertir le revêtement de dérivé d'oxyde de silicium (7) en un second film de dioxyde de silicium;
- implanter des ions du type de conductivité considéré dans le substrat (1) au travers des films de dioxyde de silicium afin de former ainsi une région dans laquelle sont implantés des ions;
- éliminer les films de dioxyde de silicium; et
- oxyder sélectivement le substrat en utilisant le film de nitrure de silicium (2) comme masque, pour former une région sélectivement oxydée comme région d'isolation ne comportant une région d'arrêt de canal (4) que sous le film d'oxyde sélectivement formé (5).

2. Procédé selon la revendication 1, comprenant entre outre les étapes consistant à:
- former une couche de résine photorésistante (6) sur le film de nitrure de silicium (2), et
- éliminer sélectivement le film de nitrure de silicium (2) pour former une ouverture (1) afin d'exposer la surface du film de dioxyde de silicium (3) par utilisation de la résine photorésistante comme masque.

3. Procédé selon la revendication 1 ou 2, dans lequel le dérivé d'oxyde de silicium est un film de silanol qui est constitué d'un silanol comme ingrédient principal.
